# EUROPÄISCHE PATENTSCHRIFT

(11) **EP 1 869 701 B1**
(45) Veröffentlichungstag und Bekanntmachung des Hinweises auf die Patenterteilung: **08.02.2017**
(21) Anmeldenummer: 06742229.5
(22) Anmeldetag: 10.04.2006
(51) Int. Cl.: H01L 21/67, H01L 23/00, H01L 21/683

(54) **VERFAHREN UND VORRICHTUNG ZUR ÜBERTRAGUNG EINES CHIPS AUF EIN KONTAKTSUBSTRAT**
METHOD AND DEVICE FOR TRANSFERRING A CHIP TO A CONTACT SUBSTRATE
PROCEDE ET DISPOSITIF POUR TRANSFERER UNE PUCE SUR UN SUPPORT DE CONTACT

(30) Priorität: 08.04.2005 DE 102005016521
(43) Veröffentlichungstag der Anmeldung: 26.12.2007
(73) Patentinhaber: Pac Tech - Packaging Technologies GmbH, 14641 Nauen (DE)
(72) Erfinder: ZAKEL, Elke, 14612 Falkensee (DE); AZDASHT, Ghassem, 13591 Berlin (DE)
(74) Vertreter: advotec.
(86) Internationale Anmeldenummer: PCT/DE2006/000628
(87) Internationale Veröffentlichungsnummer: WO 2006/105782

(56) Entgegenhaltungen:
- EP-A- 1 369 912
- WO-A-2005/024908
- DE-A1- 19 749 909
- US-B1- 6 284 086

## Beschreibung

Die vorliegende Erfindung betrifft eine Vorrichtung zur Durchführung eines Verfahrens zur Übertragung eines auf einem Transfersubstrat angeordneten Chips auf ein Kontaktsubstrat und Kontaktierung des Chips mit dem Kontaktsubstrat, bei dem der auf einer dem Kontaktsubstrat zugewandten Aufnahmefläche des Transfersubstrats mit seiner Rückseite adhäsiv befestigte Chip rückwärtig durch das Transfersubstrat hindurch mit Laserenergie beaufschlagt wird und der Chip rückwärtig durch das Transfersubstrat hindurch mittels einer Andruckeinrichtung mit seinen einer Kontaktfläche des Kontaktsubstrats gegenüberliegend angeordneten Chipkontakten in Kontakt mit auf der Kontaktfläche angeordneten Substratkontakten gebracht wird und eine thermische Verbindung zwischen den Chipkontakten und den Substratkontakten hergestellt wird.

Die DE 197 49 909 offenbart eine Vorrichtung zum Herstellen von Verbindungen zwischen jeweils zwei Kontaktelementen mittels Laserenergie.

Die Kontaktierung von Chips auf einem Substrat erfordert regelmäßig eine Handhabung der Chips, derart, dass vor Durchführung des eigentlichen Kontaktierungsvorgangs eine Positionierung des Chips gegenüber dem Substrat erfolgt, die sicherstellen soll, dass die für die erfolgreiche Kontaktierung notwendige Relativausrichtung der Chipkontakte gegenüber den Substratkontakten gegeben ist. Diese Handhabung der einzelnen Chips erfordert einen entsprechend hohen apparativen Aufwand, oftmals verbunden mit zusätzlichen Verfahrensschritten zur Positionierung der einzelnen Chips, die entsprechend lange Prozesszeiten für die Durchführung des gesamten Kontaktierungsverfahrens bedingen.

Der vorliegenden Erfindung liegt die Aufgabe zugrunde, eine Vorrichtung zur Durchführung eines Verfahrens zur Kontaktierung von Chips auf Substraten vorzuschlagen, das mit einem vergleichsweise geringen Handhabungsaufwand auskommt und eine Verkürzung der Kontaktierungszeiten ermöglicht.

Diese Aufgabe wird durch eine Vorrichtung mit den Merkmalen des Anspruchs 1 gelöst.

Bei dem Verfahren erfolgt die Kontaktierung des Chips mit einem Substrat nicht basierend auf einer unmittelbaren Handhabung des Chips, sondern vielmehr durch mechanische und thermische Beaufschlagung eines Transfersubstrats, so dass die Ausrichtung des Chips, als Voraussetzung für einen nachfolgenden Kontaktierungsvorgang, durch die Anordnung des Chips auf dem Transfersubstrat definiert ist und eine unmittelbare Handhabung des vergleichsweise geringste Abmessungen aufweisenden Chips unterbleiben kann.

Als besonders vorteilhaft erweist es sich bei der Durchführung des Verfahrens, wenn als Transfersubstrat eine Folie verwendet wird, die aufgrund der bei Folien stets sehr geringen Dicke etwa einerseits einen Träger zur definierten Anordnung des Chips bildet, andererseits jedoch einen möglichst geringen mechanischen und thermischen Widerstand darstellt, so dass bereits durch eine geringe Druckbeaufschlagung die für die Kontaktierung erforderliche Zustellbewegung des Chips ausführbar ist und eine schnelle Erwärmung des Chips zur Durchführung der thermischen Verbindung zwischen den Chipkontakten und den Substratkontakten möglich ist.

Die rückwärtige adhäsive Befestigung des Chips am Transfersubstrat ermöglicht, dass eine parallele rückwärtige Beaufschlagung des Chips mit Druck und Temperatur gleichzeitig mit Ausführung der Zustellbewegung zur Herstellung eines zunächst mechanischen Kontakts zwischen den Chipkontakten und den Substratkontakten und ein Lösen der adhäsiven Verbindung des Chips mit dem Transfersubstrat erfolgt. Gleichzeitig mit dem Lösen der adhäsiven Verbindung ermöglicht durch die mittelbare thermische Beaufschlagung des Chips eine Erwärmung der Chipkontakte mit Überleitung der Wärme in die Substratkontakte, so dass die Herstellung einer thermischen Verbindung zur mechanisch dauerhaften, elektrisch leitfähigen Verbindung zwischen den Chipkontakten und den Substratkontakten möglich ist.

Zur adhäsiven Befestigung des Chips auf dem als Folie ausgeführten Transfersubstrat eignet sich in besonderer Weise ein Kleberauftrag, der sich hinsichtlich der Wahl des Klebermaterials exakt auf die gewünschte Ablösetemperatur, also die Temperatur, bei der sich der Chip von der Folie ablöst, einstellen lässt.

Wenn der Kleberauftrag als ein auf die Folie aufgebrachter Haftkleberauftrag ausgebildet ist, ist eine Applikation des Chips auf die Folie besonders einfach möglich.

Alternativ ist es jedoch auch möglich, dass zur Verbindung des Chips mit dem Transfersubstrat ein auf dem Chip aufgebrachter Kleberauftrag vorgesehen ist.

Zur Verbindung des Chips mit dem Kontaktsubstrat, also zur sowohl mechanischen als auch elektrischen Kontaktierung des Chips auf dem Kontaktsubstrat, kann ein zwischen dem Chip und dem Kontaktsubstrat angeordneter Kleberauftrag dienen, der durch die Temperaturbeaufschlagung aushärtbar ist und im Verbindungsbereich zwischen den Chipkontakten und den Substratkontakten elektrisch leitfähig ausgestaltet ist. Dies ist beispielsweise bei einem anisotropen Kleber der Fall, der in Folge einer Druckbeaufschlagung eine Ausrichtung von elektrisch leitfähigen Kleberpartikeln im Bereich von Druckspitzen erfährt. Alternativ ist es auch möglich, zur Verbindung des Chips mit dem Kontaktsubstrat ein auf den Chipkontakten und/oder den Substratkontakten angeordnetes Lotmaterial zu verwenden, so dass zur mechanischen und elektrischen Verbindung des Chips mit dem Kontaktsubstrat eine Lotverbindung hergestellt wird.

Darüber hinaus sind auch Verbindungen zwischen dem Chip und dem Kontaktsubstrat möglich, derart, dass beispielsweise zwischen den Chipkontakten und den Substratkontakten eine Lotverbindung hergestellt wird, die in erster Linie zur Herstellung des elektrischen Kontakts dient, und im Übrigen zwischen dem Chip und dem Kontaktsubstrat ein unter Temperaturbeaufschlagung aushärtbarer Kleberauftrag nach Art eines Underfillers vorgesehen ist.

Die Vorteile des Verfahrens werden besonders offenbar, wenn gleichzeitig eine Mehrzahl auf einer gemeinsamen Folie angeordneter Chips auf ein Kontaktsubstrat oder eine Mehrzahl von Kontaktsubstraten übertragen und mit diesem bzw. diesen kontaktiert wird. Damit ist es möglich, vermittels einer einfachen Zustellbewegung, überlagert mit einer Temperaturbeaufschlagung, eine Vielzahl von Kontaktierungsvorgängen zwischen Chip und Kontaktsubstraten herzustellen, so dass das Verfahren in kürzester Zeit die Herstellung großer Stückzahlen von Bauteilgruppen, umfassend einen Chip und ein Kontaktsubstrat, ermöglicht. Zu derartigen Bauteilgruppen sind auch sogenannte "Transponder" zu zählen, die aus einem Chip bestehen, der auf einem Kontaktsubstrat angeordnet ist, dessen Substratkontakte die Enden einer Antenneneinrichtung bilden.

Eine weitere besonders vorteilhafte Variante des Verfahrens wird möglich, wenn die Chips in einer durch die Vereinzelung von Chips aus einem Waferverbund gebildeten Waferanordnung auf der Folie angeordnet sind. Hierdurch ist es möglich, die Chips in genau der Anordnung auf das Transfersubstrat zu übertragen, die sich basierend auf einer Vereinzelung der Chips aus einem Wafer, also durch ein entsprechendes Zersägen des Wafers, einstellt.

Um die Übertragung in Waferanordnung auf das Transfersubstrat in besonders einfacher Art und Weise zu ermöglichen, kann der Wafer vor dem Zersägen zur Vereinzelung der Chips mit einem Kleberauftrag versehen werden, so dass diese unmittelbar nach dem Zersägen in ihrer Gesamtheit in Waferanordnung auf das Transfersubstrat übertragen werden können, ohne dass die vereinzelten Chips hierzu einzeln gehandhabt werden müssten.

Abweichend von der vorstehend erläuterten, 1:1-Übertragung einer Waferanordnung auf das Transfersubstrat kann es jedoch auch vorteilhaft sein, eine Anordnung der Chips auf dem Transfersubstrat zu wählen, die einer Kontaktsubstratanordnung entspricht, also beispielsweise bei einer Bestückung eines einzelnen Kontaktsubstrats mit einer Mehrzahl von Chips der Anordnung der den jeweiligen Chips zugeordneten Substratkontakten. Bei einer derartigen Verfahrensvariante ist es möglich, die Kontaktierung der Gesamtheit der Chips für ein Kontaktsubstrat in einem Kontaktierungsvorgang durchzuführen.

Die erfindungsgemäße Vorrichtung weist die Merkmale des Anspruchs 1 auf und ist in besonderer Weise zur Durchführung des Verfahrens geeignet. Die erfindungsgemäße Vorrichtung umfasst insbesondere ein Transferwerkzeug, das eine Lasereinrichtung und eine Andruckeinrichtung umfasst und somit sowohl die Durchführung der Zustellbewegung zur Herstellung des mechanischen Kontakts als auch die thermische Beaufschlagung zur Herstellung der dauerhaften mechanischen und elektrischen Verbindung zwischen dem Chip und dem Kontaktsubstrat ermöglicht.

In einer besonders vorteilhaften Ausführungsform weist das Transferwerkzeug einen Werkzeugkörper zum Anschluss einer Lichtleitfaser zur Übertragung von Laserenergie und ein mit einer Laserübertragungseinrichtung versehenes Kontaktmundstück auf, so dass beide der vorgenannten Funktionen, also sowohl die Durchführung der Zustellbewegung als auch die Beaufschlagung mit Laserenergie, mit einer besonders kompakten Ausführung des Transferwerkzeugs möglich sind.

Die vorteilhafte Ausbildung des Kontaktmundstücks als Druckkapillare ermöglicht eine besonders diskrete Druckbeaufschlagung bei gleichzeitig durch die Kapillarenbohrung erfolgender unmittelbarer Laserbeaufschlagung.

Um zu verhindern, dass es bei einem Auftreffen des Kontaktmundstücks auf das Transfersubstrat zu Druckspitzen kommt, ist es vorteilhaft, wenn zwischen dem Werkzeugkörper und dem Kontaktmundstück ein unter definierter Belastung ausweichendes, insbesondere federgestütztes Kraftübertragungselement angeordnet ist.

Zur Übertragung und Kontaktierung einer Mehrzahl von Chips ist es besonders vorteilhaft, wenn eine entsprechende Mehrzahl von Transferwerkzeugen in einem Transferkopf angeordnet ist, so dass die Übertragung und Kontaktierung wahlweise simultan oder in definierter Reihenfolge erfolgen kann.

Wenn die Transferwerkzeuge darüber hinaus in einer Matrixanordnung in dem Transferkopf angeordnet sind, kann die Matrixanordnung in besonders vorteilhafter Weise beispielsweise in Übereinstimmung mit einer Waferanordnung von Chips gewählt werden.

Wenn gemäß einer weiteren bevorzugten Ausführungsform die Einrichtung zur Anordnung des Transfersubstrats eine Aufnahmeeinrichtung zur Anordnung einer Vereinzelungsfolie als Transfersubstrat mit einer Mehrzahl von Chips in Waferanordnung umfasst und mit einer Positionierungseinrichtung zur Positionierung der einzelnen Chips der Waferanordnung entsprechend der Anordnung der Chips auf dem Kontaktsubstrat versehen ist, ist es möglich, unabhängig von der Ausbildung der Kontaktsubstrate bzw. der Verteilung der Chips auf den Kontaktsubstraten basierend auf einer definierten Waferanordnung der Chips eine beliebige Verteilung von Chips auf den Kontaktsubstraten bei der Kontaktierung herzustellen.

Auch kann es vorteilhaft sein, wenn die Einrichtung zur Aufnahme des Transfersubstrats eine Bahnführungseinrichtung zur Führung eines als Folienbahn ausgebildeten Transfersubstrats umfasst und mit einer Vorschubeinrichtung zur Positionierung der einzelnen Chips entsprechend der Anordnung der Chips auf dem Kontaktsubstrat versehen ist. Somit ist es möglich, auf dem als Folienbahn ausgeführten Transfersubstrat eine Anordnung der Chips entsprechend der Verteilung der Chips auf dem bzw. den Kontaktsubstrat(en) zu wählen und basierend darauf die Kontaktierung einer Mehrzahl von Chips gleichzeitig auszuführen.

Nachfolgend werden bevorzugte Varianten des erfindungsgemäßen Verfahrens sowie Ausführungsformen erfindungsgemäßer Vorrichtungen zur Durchführung des Verfahrens anhand der Zeichnung näher erläutert. Es zeigen:
- **Fig. 1a** und **1b**: eine grundsätzliche Darstellung des Verfahrensprinzips;
- **Fig. 2**: eine Verfahrensvariante betreffend die Durchführung des Verfahrens basierend auf einem als "Sägefolie" ausgeführten Transfersubstrat;
- **Fig. 3**: eine Verfahrensvariante zur Durchführung des Verfahrens basierend auf einem als Folienbahn ausgeführten Transfersubstrat;
- **Fig. 4**: eine vergrößerte Darstellung der Vorgänge bei Durchführung des Verfahrens unmittelbar im Übertragungsbereich eines Chips;
- **Fig. 5**: eine Reihenanordnung einer Mehrzahl von Transferwerkzeugen;
- **Fig. 6**: die Durchführung des Verfahrens basierend auf einem als "Sägefolie" ausgeführten Transfersubstrat mit schematischer Darstellung eines Transferkopfs in Draufsicht.

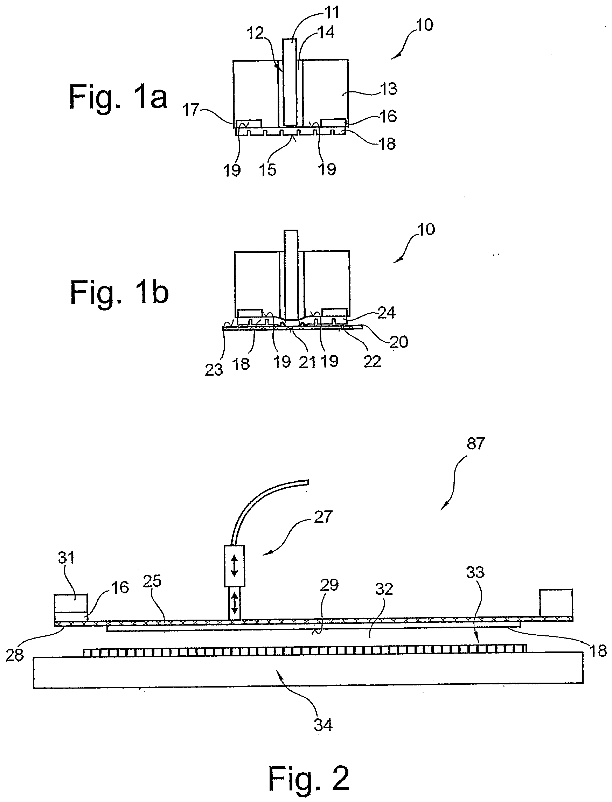

In den **Fig. 1a** und **1b** ist in einer besonders einfachen Ausführungsform ein Transferwerkzeug 10 dargestellt, umfassend eine als Lichtleitfaser 11 ausgebildete Lasereinrichtung, die im vorliegenden Fall gleichzeitig als Andruckeinrichtung 12 dient. Die Lichtleitfaser 11 ist in einem Kanal 14 eines Werkzeugkörpers 13 geführt. Die untere Stirnfläche des Werkzeugkörpers 13 dient zur Ausbildung einer Kontaktsubstrataufnahmeeinrichtung 15, an der vermittels Vakuumöffnungen 16 eine Folie 17 gehalten wird. Die Folie 17 ist mit einer Mehrzahl von Chips 18 bestückt, die vermittels einer hier nicht näher dargestellten, zwischen einer Rückseite 19 der Chips 18 und der Folie 17 ausgebildeten Kleberschicht adhäsiv an der Folie 17 gehalten werden.

**Fig. 1b** zeigt das Transferwerkzeug 10 in einer Positionierung unmittelbar oberhalb eines Kontaktsubstrats 20, in einer Übertragungskonfiguration, in der der gegenüberliegend einem freien Kontaktende 21 der Lichtleitfaser 11 angeordnete Chip 18 zur Überbrückung eines zwischen einer Kontaktoberfläche 22 des Chips 18 und einer Kontaktoberfläche 23 des Kontaktsubstrats 20 ausgebildeten Kontaktspaltes 24 zur Anlage an das Kontaktsubstrat 20 gedrängt wird. Hierzu wird die in dem vorliegenden Ausführungsbeispiel gleichzeitig als Andruckeinrichtung 12 dienende Lichtleitfaser 11 gegen die Rückseite 19 des Chips 18 bewegt.

Vorzugsweise gleichzeitig mit Ausführung der vorgenannten Zustellbewegung, spätestens jedoch nach Anlage der Kontaktoberfläche 22 des Chips 18 gegen die Kontaktoberfläche 23 des Kontaktsubstrats 20 erfolgt eine rückwärtige Beaufschlagung des Chips 18 mit Laserenergie durch die für Laserenergie transparente Folie 17 hindurch, so dass eine Erwärmung des Chips 18 die Folge ist. In Folge dieser Erwärmung werden die in der Kleberschicht zwischen der Rückseite 19 des Chips 18 und der Folie 17 wirksamen Adhäsionskräfte reduziert und die adhäsiven Kräfte eines unter Temperatur aushärtbaren Klebermaterials, das zwischen den Kontaktoberflächen 22 und 23 angeordnet ist, aktiviert. Hierdurch entsteht eine dauerhafte mechanische Verbindung zwischen dem Chip 18 und dem Kontaktsubstrat 20 bei gleichzeitigem Lösen der Verbindung zwischen der Folie 17 und der Rückseite 19 des Chips 18.

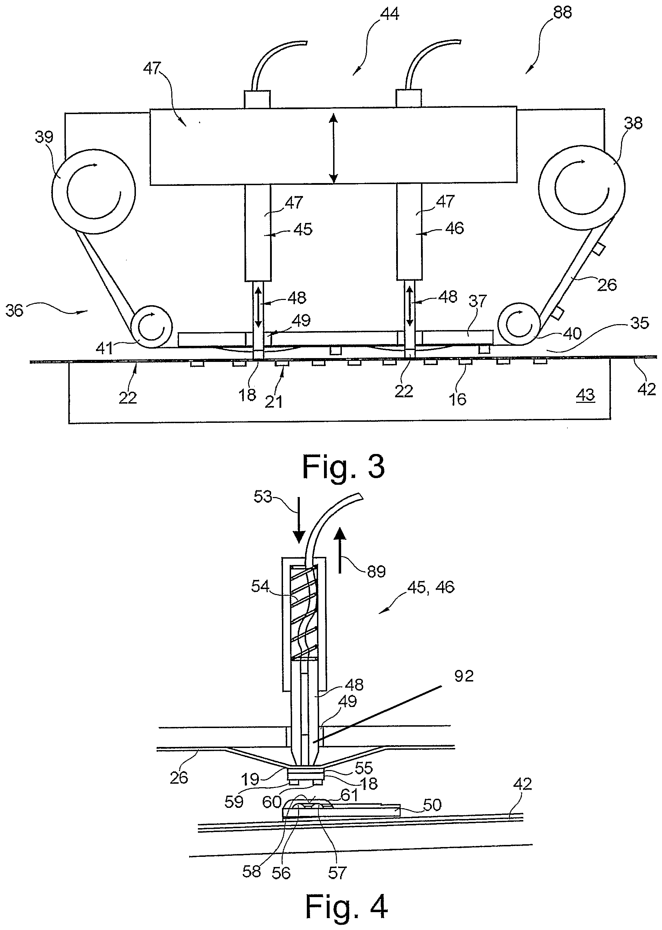

In den **Fig. 2** und **3** sind zwei mögliche Verfahrensvarianten bzw. dabei einsetzbare Vorrichtungen dargestellt, wobei in **Fig. 2** mittels einer ersten Übertragungseinrichtung 87 eine Verfahrensvariante basierend auf einer durch eine "Sägefolie" gebildeten Vereinzelungsfolie 25 durchgeführt wird, die als Transfersubstrat dient, und **Fig. 3** eine Verfahrensvariante zeigt, bei der mittels einer zweiten Übertragungsvorrichtung 88 das Verfahren basierend auf einem als Folienbahn 26 ausgeführten Transfersubstrat erfolgt.

Zur Vereinfachung der Darstellung ist in **Fig. 2** lediglich ein Transferwerkzeug 27 dargestellt, das die Vereinzelungsfolie 25 rückwärtig beaufschlagt. Auf einer Vorderseite 28 der Vereinzelungsfolie 25 befindet sich eine Vielzahl von Chips 18 in sogenannter Waferanordnung 29, d. h. die Chips 18 befinden sich exakt in der Relativanordnung, die sich als Folge eines Vereinzelungsprozesses zur Herstellung vereinzelter Chips 18 aus einem Wafer einstellt. Als Einrichtung zur Aufnahme der Vereinzelungsfolie 25 dient im vorliegenden Fall ein umlaufender Trägerrahmen 31, der in definierten Abständen mit Vakuumöffnungen 16 versehen ist, die ein Halten der Folie 25 in der in **Fig. 2** dargestellten Position ermöglichen.

Unterhalb der in Waferanordnung 29 auf der Vereinzelungsfolie 25 angeordneten Chips 18 befindet sich beabstandet durch einen Kontaktspalt 32 ein Kontaktsubstrat 33, das auf einer Kontaktsubstrataufnahmeeinrichtung 34 angeordnet ist.

Bei der in **Fig. 3** dargestellten Übertragungsvorrichtung 88 ist das Transfersubstrat im Gegensatz zu der in **Fig. 2** dargestellten Ausführung nicht als Vereinzelungsfolie 25 sondern als eine Folienbahn 26 ausgebildet, die über eine Bahnführungseinrichtung 36 an einer Folienbahnanlageeinrichtung 37 vorbei bewegt wird. Die Anordnung von Chips 18 auf der Folienbahn 26 kann derart erfolgen, dass die gesamte Waferoberfläche des Wafers vor der Vereinzelung mit einem Kleberauftrag versehen. Nach erfolgter Vereinzelung können dann die in Waferanordnung 29 angeordneten Chips 18 vermittels des auf ihrer Rückseite 19 angeordneten Kleberauftrags auf die Folienbahn 26 aufgebracht werden. Zum Transport der Folienbahn 26 weist die Bahnführungseinrichtung 36 eine Folienbahnabwickelspule 38, eine Folienbahnaufwickelspule 39 und zwei Umlenkrollen 40, 41 auf, die eine Führung der Folienbahn 26 parallel zur Folienbahnanlageeinrichtung 37 ermöglichen. Die Folienbahnanlageeinrichtung 37 umfasst eine Mehrzahl hier nicht näher dargestellter Vakuumöffnungen, die eine Anlage der Folienbahn 26 zur Einstellung eines definierten Kontaktspaltes 35 zwischen der Folienbahn 26 und einer Kontaktsubstratbahn 42, die über eine Kontaktsubstratbahnanlageeinrichtung 43 hinweg geführt wird, ermöglichen. Die Kontaktsubstratbahnanlageeinrichtung 43 ist ebenfalls mit einer Vielzahl von Vakuumöffnungen 16 versehen, die zur definierten Anlage der Kontaktsubstratbahn 42 an die Kontaktsubstratbahnanlageeinrichtung 43 dienen.

Oberhalb der Folienbahnanlageeinrichtung 37 befindet sich ein Transferkopf 44, umfassend eine Mehrzahl von Transferwerkzeugen 45, 46, die über eine Kopftraverse 51, in der Werkzeuggehäuse 47 der Transferwerkzeuge 45, 46 definiert aufgenommen sind, in einer Verbundanordnung zur Ausbildung des Transferkopfs 44 angeordnet sind. In den Werkzeugkörpern 47 der Transferwerkzeuge 45, 46 ist jeweils ein längs geführtes Zustellelement 48 aufgenommen, das jeweils in Zustellausnehmungen 49 der Folienbahnanlageeinrichtung 37 hinein ragt.

In der in **Fig. 3** dargestellten Übertragungskonfiguration der Übertragungsvorrichtung 88 durchdringen in Folge einer Zustellbewegung der Kopftraverse 51 die Zustellelemente 48 beider Transferwerkzeuge 45, 46 die Zustellausnehmungen 49 und drängen dabei auf der Folienbahn 26 adhäsiv befestigte Chips 18 gegen in **Fig. 3** nicht näher dargestellte, auf der Kontaktsubstratbahn 42 angeordnete Kontaktsubstrate 50 **(****Fig. 4****).** Wie durch den Doppelpfeil in **Fig. 3** dargestellt, ist vermittels einer entsprechenden Beaufschlagung der Kopftraverse 51 eine gleichzeitige Zustellbewegung sämtlicher Transferwerkzeuge 45, 46 des Transferkopfs 44 möglich. Bei einer entsprechend getakteten Bewegung der Folienbahn 26 längs der Folienbahnanlageeinrichtung 37 und der Kontaktsubstratbahn 42 längs der Kontaktsubstratbahnanlageeinrichtung 43 lassen sich jeweils gewünschte Überdeckungen zwischen Chips 18 und darunter liegend, getrennt durch den Kontaktspalt 35, auf der Kontaktsubstratbahn 42 angeordneten Kontaktsubstraten 50 herstellen, so wie aus der vergrößerten Teildarstellung gemäß **Fig. 4** ersichtlich.

**Fig. 4** zeigt ein Transferwerkzeug 45, 46 während der Ausführung der Zustellbewegung in Richtung eines auf der Kontaktsubstratbahn 42 angeordneten Kontaktsubstrats 50. Wie durch den Pfeil 53 angedeutet, wird die Zustellbewegung durch die Bewegung des Werkzeugkörpers 47 des Transferwerkzeugs 45, 46 ausgeführt. Das längsverschieblich im Werkzeugkörper 47 geführte Zustellelement 48 stützt sich über eine im Werkzeugkörper 47 angeordnete Federeinrichtung 54 am Werkzeugkörper 47 ab. Hierdurch wird im Moment eines Kontakts zwischen dem über seine Rückseite 19 vermittels einer Kleberschicht 55 adhäsiv mit der Folienbahn 26 verbundenen Chip 18 und dem Kontaktsubstrat 50 eine rückfedernde Ausweichbewegung des Zustellelements 48 ermöglicht, so dass Beschädigungen vorgebeugt wird. Bei dem in **Fig. 4** dargestellten Ausführungsbeispiel ist das Kontaktsubstrat 50 im Bereich seiner zwei Substratkontakte 56, 57 aufweisenden Kontaktoberfläche 58 mit einem anisotropen Klebermaterial 61 versehen, in dem sich im Bereich von Druckspitzen in Folge des Kontaktvorgangs zwischen Chipkontakten 59, 60 und den Substratkontakten 56, 57 leitende Kontaktbrücken ausbilden. In Folge der gleichzeitig mit dem Kontakt erfolgenden Temperaturbeaufschlagung der Chipkontakte 59, 60 erfolgt ein Aushärten des Klebermaterials 61 mit dauerhafter Fixierung der vorstehend erwähnten Kontaktbrücken. Spätestens zu diesem Zeitpunkt hat sich auch die durch die Kleberschicht 55 gebildete adhäsive Verbindung zwischen der Rückseite 19 des Chips 18 und der Folienbahn 26 gelöst, so dass nach einer Rückstellbewegung des Transferwerkzeugs 45, 46 in Richtung des Pfeils 89 die Kontaktierung zwischen dem Chip 18 und dem Kontaktsubstrat 50 erhalten bleibt und eine Vorschubbewegung der Folienbahn 26 sowie der Kontaktsubstratbahn 42 zur Durchführung eines nachfolgenden Übertragungs- und Kontaktierungsvorgangs erfolgen kann.

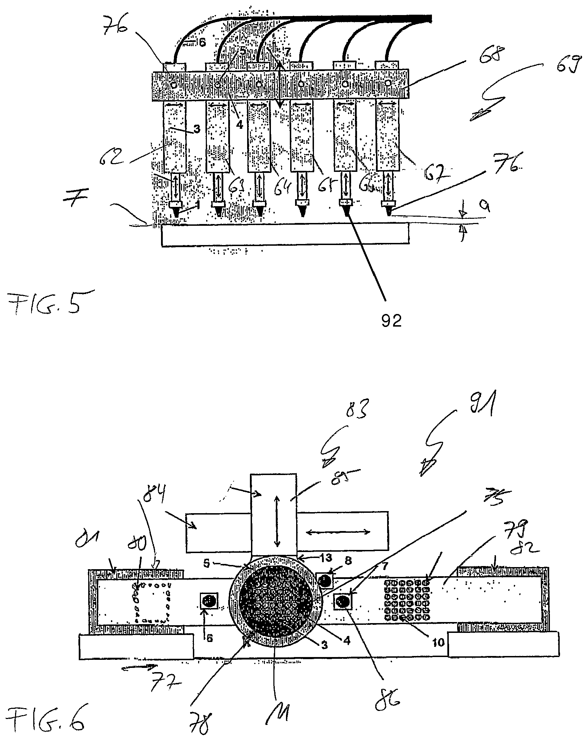

**Fig. 5** zeigt eine Mehrzahl von Transferwerkzeugen 62 bis 67, die vermittels einer gemeinsamen Kopftraverse 68 zu einer Reihenanordnung 69 zusammengefasst sind. Die einzelnen Transferwerkzeuge 62 bis 67 entsprechen dabei in ihrem Aufbau und in ihrer Funktion den vorstehend unter Bezugnahme auf die **Fig. 3** und 4 bereits erläuterten Transferwerkzeugen 45, 46.

Bei dem in **Fig. 5** dargestellten Ausführungsbeispiel sind insgesamt sechs Transferwerkzeuge 62 bis 67 zu der Reihenanordnung 69 zusammengefasst. Natürlich ist es auch möglich, hiervon abweichende Anzahlen von Transferwerkzeugen zu einer Reihenanordnung zusammenzufassen und die Reihenanordnung mit weiteren Reihenanordnungen 70 bis 74 zu einer Matrixanordnung 75 **(****Fig. 6****)** zu kombinieren. Zur Justierung der Relativausrichtung der einzelnen Transferwerkzeuge 62 bis 67 der Reihenanordnung 69 untereinander sind bei dem in **Fig. 5** dargestellten Ausführungsbeispiel Justiereinrichtungen 76 vorgesehen, die sowohl die Relativausrichtung der Längsachsen der Transferwerkzeuge 62 bis 67 untereinander als auch eine einheitliche Höheneinstellung der Transferwerkzeuge 62 bis 67 zur Ausbildung eines gleichmäßigen Abstands a zwischen einem Kontaktmundstück 92 der Transferwerkzeuge 62 bis 67 und einer Bezugsfläche F ermöglichen.

Bei dem in **Fig. 6** dargestellten Ausführungsbeispiel, besteht wie in **Fig. 2****,** die Vereinzelungsfolie 25 aus einer sogenannten "Sägefolie". Damit ist die Vereinzelungsfolie 25 ein und dieselbe Folie, die zur Herstellung einer Mehrzahl von vereinzelten Chips durch ein Zersägen eines Wafers dient. Hierbei ist es Stand der Technik, den Wafer zur Durchführung des Vereinzelungsvorgangs, also zur Handhabung des Wafers beim Sägevorgang, auf einer Folie, der sogenannten "Sägefolie", anzuordnen. Nach Durchführung des Sägevorgangs befinden sich die vereinzelten Chips in einer sogenannten Waferanordnung auf der Sägefolie. Bei der in **Fig. 6** dargestellten Übertragungsvorrichtung 91dient diese Sägefolie oder Vereinzelungsfolie 25 als Transfersubstrat zur Durchführung des Verfahrens zu verwenden.

Wie **Fig. 6** zeigt, wird zur gleichzeitigen Übertragung der Mehrzahl von Chips in Waferanordnung ein Transferkopf 78 verwendet, der in **Fig. 6** lediglich durch schematische Darstellung der einzelnen Lichtleitfasern 11, die den in Reihenanordnungen 69 bis 74 angeordneten Transferwerkzeugen zugeordnet sind, angedeutet ist.

Unterhalb der Vereinzelungsfolie 25 mit den rückseitig darauf, in **Fig. 6** nicht dargestellten, in Waferanordnung angeordneten Chips befindet sich eine Kontaktsubstratbahn 79, auf der Kontaktsubstratanordnungen 80 mit einer Mehrzahl von hier nicht näher dargestellten Kontaktsubstraten angeordnet sind, die hinsichtlich der Anordnung ihrer Substratkontakte der durch die Waferanordnung der Chips vorgegebenen Anordnung der Chipkontakte entsprechen können oder auch hiervon abweichen können. Die Kontaktsubstratanordnungen 80 können vermittels geeigneter Transporteinrichtungen 81, 82 durch Vorbewegung der Kontaktsubstratbahn 79 in Vorschubrichtung 77 unter die Waferanordnung auf der Vereinzelungsfolie 25 bewegt werden. Bei einer übereinstimmenden Anordnung der Substratkontakte mit den Chipkontakten kann die gesamte Waferanordnung von Chips in einem Übertragungs- und Kontaktierungsvorgang auf die Kontaktsubstrate der Kontaktsubstratanordnung 80 übertragen werden, analog der Darstellung in **Fig. 4****.** Bei abweichender Anordnung zwischen den Substratkontakten der Kontaktsubstratanordnung und den Chipkontakten der in Waferanordnung angeordneten Chips kann auch eine Übertragung und Kontaktierung der Chips einzeln oder in Gruppen erfolgen, wobei die geeignete Relativpositionierung der Chips zu den Kontaktsubstraten über eine entsprechende Steuereinrichtung 83 mit Bewegungsachsen 84 und 85 erfolgen kann. Die Ansteuerung der Steuereinrichtung 83 kann vermittels Kameraeinrichtungen 86 kombiniert mit einer Bildverarbeitungseinrichtung erfolgen.

Zur Herstellung der Kontaktierung zwischen den Chips und den Kontaktsubstraten kann bei dem in **Fig. 6** dargestellten Ausführungsbeispiel, ähnlich wie schon unter Bezugnahme auf die **Fig. 4** erläutert, ein thermisch aktivierbarer Kleberauftrag zwischen dem Chip und dem Kontaktsubstrat vorgesehen sein. Hierbei hat es sich auch als vorteilhaft herausgestellt, wenn als Klebermaterial ein Material verwendet wird, das zur Herstellung der Leitfähigkeit Aktivkohlefasern enthält. Alternativ kann auch die Durchführung einer Lötkontaktierung erfolgen, wobei beispielsweise ein Lötmaterialauftrag auf den Chipkontakten und/oder den Kontaktsubstratkontakten vorgesehen sein kann. Auch ist es möglich, die Chipkontakte mit einer Kontaktmetallisierung zu versehen, die aus einer stromlos abgeschiedenen Nickel-Gold-Beschichtung besteht.

## Patentansprüche

1. Vorrichtung zur Übertragung eines auf einem Transfersubstrat (17, 25, 26) angeordneten Chips (18) auf ein Kontaktsubstrat (20, 33, 50) und Kontaktierung des Chips mit dem Kontaktsubstrat mit einer Einrichtung (31, 36, 37) zur Anordnung eines mit zumindest einem Chip versehenen Transfersubstrats, einem Transferwerkzeug (45, 46, 62 bis 67) umfassend eine Lasereinrichtung (11) und eine Andruckeinrichtung (12, 48) und einer Einrichtung (34, 43) zur Anordnung von zumindest einem Kontaktsubstrat, wobei sowohl die Lasereinrichtung als auch die Andruckeinrichtung derart angeordnet sind, dass sie unter zwischenliegender Anordnung des Transfersubstrats eine rückwärtige Beaufschlagung des über seine Rückseite (19) mit dem Transfersubstrat verbundenen Chips mit Druck und Temperatur zur Übertragung des Chips auf das Kontaktsubstrat und Kontaktierung des Chips mit dem Kontaktsubstrat ermöglichen,
mit den weiteren Merkmalen, dass das Transferwerkzeug (45, 46, 62 bis 67) einen Werkzeugkörper (47) zum Anschluss einer Lichtleitfaser (11) zur Übertragung von Laserenergie und ein mit einer Laserübertragungseinrichtung versehenes, als Druckkapillare ausgebildetes Kontaktmundstück (92) aufweist,
und dass zwischen dem Werkzeugkörper (47) und dem Kontaktmundstück (92) ein federgestütztes Kraftübertragungselement (48) angeordnet ist
und dass zur Übertragung und Kontaktierung einer Mehrzahl von Chips (18) eine Mehrzahl von derartigen Transferwerkzeugen (62 bis 67) in einem Transferkopf (78) angeordnet ist.

2. Vorrichtung nach Anspruch 1,
**dadurch gekennzeichnet,**
**dass** die Transferwerkzeuge (62 bis 67) in einer Matrixanordnung (75) in dem Transferkopf (78) angeordnet sind.

3. Vorrichtung nach Anspruch 2
**dadurch gekennzeichnet,**
**dass** die Transferwerkzeuge (62 bis 67) in einer oder mehreren Reihenanordnungen (69 bis 74) angeordnet sind.

4. Vorrichtung nach einem der Ansprüche 1 bis 3
**dadurch gekennzeichnet,**
**dass** die Einrichtung (31) zur Anordnung des Transfersubstrats eine Aufnahmeeinrichtung zur Anordnung einer Vereinzelungsfolie (25) als Transfersubstrat mit einer Mehrzahl von Chips (18) in Waferanordnung (29) umfasst und mit einer Positionierungseinrichtung (83, 86) zur Positionierung der einzelnen Chips der Waferanordnung entsprechend der Anordnung der Chips auf dem Kontaktsubstrat versehen ist.

5. Vorrichtung nach einem der Ansprüche 1 bis 3
**dadurch gekennzeichnet,**
**dass** die Einrichtung (36, 37) zur Aufnahme des Transfersubstrats eine Bahnführungseinrichtung zur Führung eines als Folienbahn (26) ausgebildeten Transfersubstrats umfasst und mit einer Vorschubeinrichtung (39) zur Positionierung der einzelnen Chips (18) entsprechend der Anordnung der Chips auf dem Kontaktsubstrat versehen ist.

## Claims

1. A device for transferring a chip (18) arranged on a transfer substrate (17, 25, 26) to a contact substrate (20, 33, 50), and for contacting the chip with the contact substrate, having a device (31, 36, 37) for arranging a transfer substrate provided with at least one chip, a transfer tool (45, 46, 62 to 67) comprising a laser device (11) and a pressing device (12, 48), and a device (34, 43) for arranging at least one contact substrate, wherein both the laser device and the pressing device are arranged in such a manner that, with the transfer substrate arranged therebetween, they enable the chip, whose rear side (19) is connected to the transfer substrate, to be subjected to pressure and heat from behind so as to transfer the chip onto the contact substrate and to contact the chip with the contact substrate,
comprising the additional features that
the transfer tool (45, 46, 62 to 67) has a tool body (47) for connecting an optical fibre (11) for transferring laser energy, and a contact mouthpiece (92) provided with a laser transfer device and formed as a pressure capillary,
and that a spring-supported force transfer element (48) is arranged between the tool body (47) and the contact mouthpiece (92), and that a plurality of transfer tools (62 to 67) of this type is arranged in a transfer head (78) for transferring and contacting a plurality of chips (18).

2. The device according to claim 1,
**characterised in that**
the transfer tools (62 to 67) are arranged in a matrix arrangement (75) in the transfer head (78).

3. The device according to claim 2,
**characterised in that**
the transfer tools (62 to 67) are arranged in one or more row arrangements (69 to 74).

4. The device according to any one of the claims 1 to 3,
**characterised in that**
the device (31) for arranging the transfer substrate comprises a receiving device for arranging a separating foil (25) as the transfer substrate having a plurality of chips (18) in a wafer arrangement (29), and is provided with a positioning device (83, 86) for positioning the individual chips of the wafer arrangement according to the arrangement of the chips on the contact substrate.

5. The device according to any one of the claims 1 to 3,
**characterised in that**
the device (36, 37) for receiving the transfer substrate comprises a sheet guidance device for guiding a transfer substrate designed as a foil sheet (26), and is provided with a feed device (39) for positioning the individual chips (18) according to the arrangement of the chips on the contact substrate.

## Revendications

1. Dispositif pour transférer une puce (18) disposée sur un substrat de transfert (17, 25, 26) à un substrat de contact (20, 33, 50) et pour contacter la puce avec le substrat de contact, ayant un dispositif (31, 36, 37) pour disposer un substrat de transfert pourvu d'au moins une puce, un outil de transfert (45, 46, 62 à 67) comprenant un dispositif laser (11) et un dispositif de pression (12, 48), et un dispositif (34, 43) pour disposer au moins un substrat de contact, tant le dispositif laser que le dispositif de pression étant disposés de telle manière que, avec le substrat de transfert interposé, lesdits dispositifs permettent à la puce, dont la face arrière (19) est reliée au substrat de transfert, d'être soumise à de la pression et de la chaleur par l'arrière pour transférer la puce au substrat de contact et pour contacter la puce avec le substrat de contact,
ayant les autres caractéristiques que
l'outil de transfert (45, 46, 62 à 67) comprend un corps d'outil (47) pour relier une fibre optique (11) pour transférer de l'énergie laser et une pièce buccale de contact (92) pourvue d'un dispositif de transfert d'énergie laser et formée en tant que capillaire de pression,
et qu'un élément de transmission de force (48) supporté par un ressort est disposé entre le corps d'outil (47) et la pièce buccale de contact (92),
et qu'une pluralité de tels outils de transfert (62 à 67) est disposée dans une tête de transfert (78) pour transférer et contacter une pluralité de puces (18).

2. Dispositif selon la revendication 1,
**caractérisé en ce que**
les outils de transfert (62 à 67) sont disposés dans un agencement de matrice (75) dans la tête de transfert (78).

3. Dispositif selon la revendication 2,
**caractérisé en ce que**
les outils de transfert (62 à 67) sont disposés dans un ou plusieurs agencements en rangées (69 à 74).

4. Dispositif selon l'une quelconque des revendications 1 à 3,
**caractérisé en ce que**
le dispositif (31) pour disposer le substrat de transfert comprend un dispositif de réception pour disposer une feuille de séparation (25) en tant que substrat de transfert ayant une pluralité de puces (18) en agencement de tranche (29) et est pourvu d'un dispositif de positionnement (83, 86) pour positionner les puces individuelles de l'agencement de tranche conformément à l'ensemble des puces sur le substrat de contact.

5. Dispositif selon l'une quelconque des revendications 1 à 3,
**caractérisé en ce que**
le dispositif (36, 37) pour recevoir le substrat de transfert comprend un dispositif de guidage de bande pour guider un substrat de transfert formé en tant que bande de feuille (26) et est pourvu d'un dispositif d'avance (39) pour positionner les puces individuelles (18) conformément à l'ensemble de puces sur le substrat de contact.
